# EUROPÄISCHE PATENTSCHRIFT

(11) **EP 2 912 688 B1**
(45) Veröffentlichungstag und Bekanntmachung des Hinweises auf die Patenterteilung: **20.02.2019**
(21) Anmeldenummer: 13783277.0
(22) Anmeldetag: 16.10.2013
(51) Int. Cl.: H01L 25/075, H01L 33/50

(54) **LEUCHTDIODENMODUL**
LED MODULE
MODULE DEL

(30) Priorität: 24.10.2012 DE 102012219460
(43) Veröffentlichungstag der Anmeldung: 02.09.2015
(73) Patentinhaber: OSRAM GmbH, 80807 München (DE)
(72) Erfinder: WINDISCH, Reiner, Pettendorf 93186 (DE); BERGENEK, Krister, Regensburg 93059 (DE)
(86) Internationale Anmeldenummer: PCT/EP2013/071670
(87) Internationale Veröffentlichungsnummer: WO 2014/063976

(56) Entgegenhaltungen:
- WO-A1-2005/062391
- DE-A1-102011 013 504
- US-A1- 2007 223 219
- DONG Y ET AL: "Luminescence studies of Ce:YAG using vacuum ultraviolet synchrotron radiation", MATERIALS RESEARCH BULLETIN, ELSEVIER, KIDLINGTON, GB, Bd. 41, Nr. 10, 12. Oktober 2006 (2006-10-12), Seiten 1959-1963, XP028078033, ISSN: 0025-5408, DOI: 10.1016/J.MATERRESBULL.2006.02.035 [gefunden am 2006-10-12]

## Beschreibung

Es wird ein Leuchtdiodenmodul angegeben.

Eine zu lösende Aufgabe besteht darin, ein Leuchtdiodenmodul anzugeben, das nach einem Einschalten eine geringe Veränderung eines Farborts einer emittierten Strahlung aufzeigt.

Die Offenlegungsschrift DE 102011013504 A1 offenbart eine Licht emittierende Vorrichtung mit einem ersten Licht emittierenden Halbleiterbauelement, das im Betrieb rotes Licht abstrahlt, einem zweiten Licht emittierenden Halbleiterbauelement mit einem Wellenlängenkonversionselement und einem dritten Licht emittierenden Halbleiterbauelement mit einen Wellenlängenkonversionselement angegeben, wobei das zweite und dritte Licht emittierende Halbleiterbauelement jeweils blaues Primärlicht und konvertiertes Sekundärlicht abstrahlen.

Diese Aufgabe wird unter anderem durch ein Leuchtdiodenmodul mit den Merkmalen des unabhängigen Patentanspruchs gelöst. Bevorzugte Weiterbildungen sind Gegenstand der abhängigen Ansprüche.

Gemäß zumindest einer Ausführungsform ist das Modul ein Leuchtdiodenmodul. Das bedeutet, dass ein Hauptanteil oder eine gesamte in dem Modul erzeugte Strahlung durch optoelektronische Halbleiterchips wie Leuchtdioden erzeugt wird. Die Leuchtdioden basieren bevorzugt auf einem anorganischen Halbleitermaterial. Es ist möglich, dass das Leuchtdiodenmodul weitere, nicht zu einer Strahlungserzeugung vorgesehene Halbleiterchips aufweist. Solche Halbleiterchips können zum Schutz vor Schäden vor elektrostatischen Entladungen dienen oder auch zum Ansteuern einzelner, strahlungserzeugender Komponenten des Leuchtdiodenmoduls.

Gemäß zumindest einer Ausführungsform umfasst das Leuchtdiodenmodul mindestens einen ersten Leuchtdiodenchip. Der erste Leuchtdiodenchip ist zur Erzeugung von Strahlung im blauen Spektralbereich eingerichtet. Die von dem ersten Leuchtdiodenchip im Betrieb erzeugte Strahlung weist eine erste Hauptwellenlänge auf. Die Hauptwellenlänge, englisch peak wavelength, ist diejenige Wellenlänge, bei der eine maximale Intensität erzeugt wird.
Gemäß zumindest einer Ausführungsform weist das Leuchtdiodenmodul einen zweiten Leuchtdiodenchip auf. Der mindestens eine zweite Leuchtdiodenchip ist zur Erzeugung von Strahlung im blauen Spektralbereich mit einer zweiten Hauptwellenlänge eingerichtet. Die erste und die zweite Hauptwellenlänge können gleich oder voneinander verschieden sein.
Gemäß zumindest einer Ausführungsform beinhaltet das Leuchtdiodenmodul einen dritten Leuchtdiodenchip. Der mindestens eine dritte Leuchtdiodenchip ist dazu eingerichtet, im Betrieb eine Strahlung im roten Spektralbereich zu erzeugen. Von dem dritten Leuchtdiodenchip wird also Strahlung einer dritten Hauptwellenlänge emittiert.
Die Leuchtdiodenchips weisen jeweils eine Halbleiterschichtenfolge mit mindestens einer aktiven Schicht auf. Bevorzugt handelt es sich bei den Leuchtdiodenchips jeweils um separate, nicht monolithisch integrierte Halbleiterkörper. Die aktiven Schichten der jeweiligen Halbleiterkörper sind bevorzugt unabhängig voneinander bestrombar. Hinsichtlich des ersten und des zweiten Leuchtdiodenchips ist es auch möglich, dass diese Leuchtdiodenchips einen gemeinsamen Halbleiterkörper aufweisen, wobei eine aktive Zone sich jedoch nicht über den ersten und zweiten Leuchtdiodenchip durchgehend erstreckt.

Die Halbleiterschichtenfolge basiert bevorzugt auf einem III-V-Verbindungshalbleitermaterial. Bei dem Halbleitermaterial handelt es sich zum Beispiel um ein Nitrid-Verbindungshalbleitermaterial wie AlₙIn₁₋ₙ₋ₘGaₘN oder um ein Phosphid-Verbindungshalbleitermaterial wie AlₙIn₁₋ₙ₋ₘGaₘP oder auch um ein Arsenid-Verbindungshalbleitermaterial wie AlₙIn₁₋ₙ₋ₘGaₘAs, wobei jeweils 0 ≤ n ≤ 1, 0 ≤ m ≤ 1 und n + m ≤ 1 ist. Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, As, Ga, In, N oder P, angegeben, auch wenn diese teilweise durch geringe Mengen weiterer Stoffe ersetzt und/oder ergänzt sein können. Bevorzugt basieren der erste und der zweite Leuchtdiodenchip auf AlInGaN und der dritte Leuchtdiodenchip basiert auf AlInGaP.

Gemäß zumindest einer Ausführungsform beinhaltet das Leuchtdiodenmodul einen ersten Leuchtstoff oder eine erste Leuchtstoffmischung. Der erste Leuchtstoff ist dem ersten Leuchtdiodenchip nachgeordnet. Das bedeutet, dass ein überwiegender Anteil oder die gesamte von dem ersten Leuchtdiodenchip emittierte Strahlung zu dem ersten Leuchtstoff gelangt. Der erste Leuchtstoff kann mittelbar oder unmittelbar auf dem ersten Leuchtdiodenchip angebracht sein.

Gemäß zumindest einer Ausführungsform beinhaltet das Leuchtdiodenmodul einen zweiten Leuchtstoff oder eine zweite Leuchtstoffmischung. Der zweite Leuchtstoff ist unmittelbar oder mittelbar an dem zweiten Leuchtdiodenchip angebracht und, entlang einer Hauptabstrahlrichtung, dem zweiten Leuchtdiodenchip nachgeordnet.

Gemäß zumindest einer Ausführungsform ist das Leuchtdiodenmodul zur Abstrahlung von weißem Licht eingerichtet. Weißes Licht bedeutet beispielsweise, dass ein Farbort einer von dem Leuchtdiodenmodul emittierten Gesamtstrahlung in der CIE-Normfarbtafel einen Abstand zur Schwarzkörperkurve, auch als Planck-Kurve bezeichnet, von höchstens 0,03 Einheiten oder von höchstens 0,015 Einheiten aufweist. Bevorzugt liegt die korrelierte Farbtemperatur, englisch Correlated Color Temperature, kurz CCT, zwischen einschließlich 2400 K und 7000 K.

Gemäß zumindest einer Ausführungsform emittiert der erste Leuchtdiodenchip zusammen mit dem ersten Leuchtstoff eine erste Mischstrahlung. Ebenso emittiert der zweite Leuchtdiodenchip zusammen mit dem zweiten Leuchtstoff eine zweite Mischstrahlung. Bevorzugt liegen die Farborte, englisch auch Color Locus oder Chromaticity Coordinate, in der CIE-Normfarbtafel oberhalb der Planck-Kurve. Insbesondere handelt es sich bei den Mischstrahlungen um weiß-grünes Licht, englisch als Mint bezeichnet. Eine cₓ-Koordinate des Farborts der Mischstrahlungen beträgt bevorzugt mindestens 0,15 und eine c_{y}-Koordinate liegt bevorzugt bei mindestens 0,25.

Gemäß zumindest einer Ausführungsform weist der erste Leuchtstoff ein erstes Absorptionsmaximum auf. Das erste Absorptionsmaximum liegt bei einer Wellenlänge, die größer ist als die erste Hauptwellenlänge der von dem ersten Leuchtdiodenchip erzeugten Strahlung. Es ist möglich, dass eine Absorption des ersten Leuchtstoffs bei der ersten Hauptwellenlänge hin zu größeren Wellenlängen zunimmt.

Gemäß zumindest einer Ausführungsform weist der zweite Leuchtstoff ein zweites Absorptionsmaximum auf. Das zweite Absorptionsmaximum ist bevorzugt von dem ersten Absorptionsmaximum verschieden. Das zweite Absorptionsmaximum liegt bei einer Wellenlänge, die kleiner ist als die zweite Hauptwellenlänge. Bei der zweiten Hauptwellenlänge kann die Absorption des zweiten Leuchtstoffs, in Richtung hin zu größeren Wellenlängen, abnehmen. Im Bereich der ersten und/oder der zweiten Hauptwellenlänge können der erste Leuchtstoff und der zweite Leuchtstoff, hinsichtlich des Verlaufs der Absorption, Steigungen mit unterschiedlichem Vorzeichen aufweisen. Es ist nicht ausgeschlossen, dass das Absorptionsmaximum bei deutlich kürzeren Wellenlängen liegt als die zweite Hauptwellenlänge. So kann das zweite Absorptionsmaximum auch im ultravioletten Spektralbereich liegen.

In mindestens einer Ausführungsform umfasst das Leuchtdiodenmodul mindestens einen ersten Leuchtdiodenchip, der zur Erzeugung von Strahlung im blauen Spektralbereich mit einer ersten Hauptwellenlänge eingerichtet ist und mindestens einen zweiten Leuchtdiodenchip, der zur Erzeugung von Strahlung im blauen Spektralbereich mit einer zweiten Hauptwellenlänge eingerichtet ist. Mindestens ein dritter Leuchtdiodenchip des Leuchtdiodenmoduls ist zur Erzeugung von Strahlung im roten Spektralbereich mit einer dritten Hauptwellenlänge eingerichtet. Ein erster Leuchtstoff ist dem ersten Leuchtdiodenchip nachgeordnet und ein zweiter Leuchtstoff dem zweiten Leuchtdiodenchip. Das Leuchtdiodenmodul ist zur Abstrahlung von weißem Licht eingerichtet. Der erste Leuchtdiodenchip zusammen mit dem ersten Leuchtstoff emittiert eine erste Mischstrahlung und der zweite Leuchtdiodenchip erzeugt zusammen mit dem zweiten Leuchtstoff eine zweite Mischstrahlung. Der erste Leuchtstoff weist ein erstes Absorptionsmaximum bei einer Wellenlänge auf, die größer ist als die erste Hauptwellenlänge. Ein zweites Absorptionsmaximum des zweiten Leuchtstoffs liegt bei einer Wellenlänge, die kleiner ist als die zweite Hauptwellenlänge.

Vor allem bei Lichtquellen mit Leuchtdioden, kurz LEDs, die einen hohen Farbwiedergabeindex, kurz RA, aufweisen sollen, wird eine Kombination aus im blauen Spektralbereich emittierenden InGaN-Leuchtdiodenchips und von im roten Spektralbereich emittierenden InGaAlP-Leuchtdiodenchips eingesetzt. Diese auf verschiedenen Materialien basierenden Leuchtdiodenchips weisen einen unterschiedlichen Temperaturgang der Effizienz auf. Ändert sich nach einem Einschalten des Leuchtdiodenmoduls eine Temperatur der Leuchtdiodenchips bis zum Erreichen einer stationären Betriebstemperatur, so führt dies zu einem vergleichsweise starken Verschieben eines Summenfarborts der von dem Leuchtdiodenmodul emittierten Gesamtstrahlung.

Ein solches Verschieben des Summenfarborts geschieht beispielsweise auf einer Zeitskala von mindestens fünf Minuten oder von mindestens zehn Minuten und/oder von höchstens 60 Minuten oder von höchstens 30 Minuten oder von höchstens 20 Minuten. Eine solche Verschiebung nach dem Einschalten ist insbesondere in der Allgemeinbeleuchtung oder in der Beleuchtung von Anzeigeeinrichtungen, die teilweise nur eine kurze mittlere Einschaltdauer aufweisen, unerwünscht. Bei sicherheitsrelevanten Anwendungen, etwa in Scheinwerfern für Kraftfahrzeuge, ist eine solche Farbortverschiebung teilweise ebenso nicht tolerierbar.

Eine Möglichkeit, eine Farbortverschiebung mit dem Temperaturgang zu vermeiden, ist eine elektronische Korrektur. Hierdurch wird die Temperatur über einen Sensor gemessen und dann elektronisch über eine Steuereinheit nachgeregelt. Diese Nachregelung ist jedoch technisch vergleichsweise aufwändig und mit relativ hohen Kosten verbunden. Da Leuchtdiodenchips zudem nur in einem bestimmten Strombereich eine hohe Effizienz aufweisen, kann ein Kosten-Effizienz-Verhältnis verringert sein.

Durch die angegebene Wahl der Hauptwellenlängen und der Leuchtstoffe ist eine geringe Farbortverschiebung in Abhängigkeit von der Temperatur bei einer hohen Effizienz und bei einem hohen Farbwiedergabeindex erreichbar.

Das Leuchtdiodenmodul weist zwei verschiedene Leuchtstoffe auf mit unterschiedlicher Absorptionscharakteristik im blauen Spektralbereich. Steigt die Temperatur des ersten Leuchtdiodenchips an und verschiebt sich dessen Hauptwellenlänge hin zu größeren Wellenlängen, so nimmt der relative Anteil von im ersten Leuchtstoff absorbierter und umgewandelter Strahlung des ersten Leuchtdiodenchips ab. Ferner wird ein zunehmender Anteil von Strahlung vom zweiten Leuchtdiodenchip in dem zweiten Leuchtstoff absorbiert. Dies führt insbesondere dazu, dass sich ein Farbort der von dem Leuchtdiodenmodul emittierten Gesamtstrahlung bei Temperaturänderung nicht oder weniger stark verschiebt.

Bei herkömmlichen Konversionsmitteln mit nur einem Leuchtstoff, der insbesondere auf einem Granat wie YAG:Ce basiert, verschiebt sich mit zunehmender Temperatur eine Emissionswellenlänge hin zu kürzeren Wellenlängen. Da sich eine Emission des dritten, im roten Spektralbereich emittierenden Leuchtdiodenchips mit steigender Temperatur auch zu größeren Wellenlängen hin verschiebt, bildet sich im gesamten, von dem Leuchtdiodenmodul emittierten Strahlungsspektrum eine Lücke aus. Diese Lücke im Emissionsspektrum führt zu einer Abnahme des Farbwiedergabeindexes bei zunehmender Temperatur der Leuchtdiodenchips sowie der Leuchtstoffe. Ein von der Temperatur abhängiger Farbwiedergabeindex ist in vielen Anwendungen jedoch unerwünscht. Dadurch, dass das Leuchtdiodenmodul die zwei Leuchtstoffe aufweist, ist eine solche spektrale Lücke bei zunehmender Temperatur hin zur stationären Betriebstemperatur vermeidbar und ein von der Temperatur unabhängiger Farbwiedergabeindex ist realisierbar.

Gemäß zumindest einer Ausführungsform weist der erste Leuchtstoff eine dominante Emissionswellenlänge von mindestens 570 nm oder von mindestens 572 nm oder von mindestens 574 nm auf. Eine dominante Emissionswellenlänge des zweiten Leuchtstoffs liegt alternativ oder zusätzlich bei höchstens 570 nm oder bei höchstens 566 nm oder bei höchstens 562 nm. Es ist hierbei die dominante Wellenlänge insbesondere diejenige Wellenlänge, die sich als Schnittpunkt der Spektralfarblinie der CIE-Normfarbtafel mit einer geraden Linie ergibt, wobei diese gerade Linie, ausgehend vom Weißpunkt in der CIE-Normfarbtafel, durch den tatsächlichen Farbort der Strahlung verläuft. Im Allgemeinen ist die dominante Wellenlänge von der Hauptwellenlänge verschieden.

Gemäß zumindest einer Ausführungsform liegt das erste Absorptionsmaximum des ersten Leuchtstoffs bei mindestens 450 nm oder bei mindestens 452 nm. Alternativ oder zusätzlich liegt das erste Absorptionsmaximum bei höchstens 470 nm oder bei höchstens 465 nm oder bei höchstens 460 nm.

Gemäß zumindest einer Ausführungsform liegt das zweite Absorptionsmaximum des zweiten Leuchtstoffs bei mindestens 425 nm oder bei mindestens 430 nm. Alternativ oder zusätzlich liegt das zweite Absorptionsmaximum bei höchstens 442 nm oder bei höchstens 439 nm.
Gemäß zumindest einer Ausführungsform liegt die erste Hauptwellenlänge und/oder die zweite Hauptwellenlänge bei mindestens 440 nm oder bei mindestens 442 nm. Alternativ oder zusätzlich liegt dieser Wert bei höchstens 465 nm oder bei höchstens 462 nm.
Gemäß zumindest einer Ausführungsform liegt die dritte Hauptwellenlänge bei mindestens 610 nm oder bei mindestens 615 nm. Alternativ oder zusätzlich beträgt die dritte Hauptwellenlänge höchstens 670 nm oder höchstens 660 nm.

Dem erfindungsgemäßen Leuchtdiodenmodul zufolge, kann ein Farbort der ersten Mischstrahlung in der CIE-Normfarbtafel auf oder innerhalb eines Vierecks mit den Eckpunkten mit den folgenden Koordinaten: (0,32; 0,36), (0,48; 0,48), (0,40; 0,56) und (0,32; 0,40) oder (0,32; 0,40), (0,42; 0,44), (0,46; 0,50) und (0,38; 0,52) liegen. Die Eckpunkte sind hierbei in Koordinatenform (cₓ; c_{y}) angegeben. Dieser Zielfarbortbereich der ersten Mischstrahlung lässt sich einstellen, einerseits durch eine Wahl der ersten Hauptwellenlänge und durch die Menge des ersten Leuchtstoffs, der dem ersten Leuchtdiodenchip nachgeordnet ist. Die Angabe des Farbortbereichs entspricht somit einer Angabe des Anteils der von dem ersten Leuchtstoff umzuwandelnden Strahlung und der ersten Hauptwellenlänge.

Dem erfindungsgemäßen Leuchtdiodenmodul zufolge, kann ein Farbort der zweiten Mischstrahlung in oder auf einem Viereck mit den folgenden Eckpunkten: (0,22; 0,20), (0,30; 0,40), (0,24; 0,46) und (0,18; 0,22 oder (0,20; 0,28), (0,24; 0,26), (0,28; 0,34) und (0,24; 0,38) liegen.

Dem erfindungsgemäßen Leuchtdiodenmodul zufolge, kann ein Mischfarbort aus der ersten Mischstrahlung und aus der zweiten Mischstrahlung in oder auf einem Viereck mit den folgenden Eckpunkten: (0,34; 0,38), (0,42; 0,44), (0,38; 0,46) und (0,32; 0,42) liegen. Durch den Mischfarbort ist ein Verhältnis aus den Intensitäten der ersten Mischstrahlung und der zweiten Mischstrahlung vorgegeben. Der Farbortbereich für den Mischfarbort gibt also an, in welchem Verhältnis die erste Mischstrahlung mit der zweiten Mischstrahlung zu mischen ist.

Dem erfindungsgemäßen Leuchtdiodenmodul zufolge, kann ein Farbort der ersten Mischstrahlung zusammen mit der von dem dritten Leuchtdiodenchip emittierten Strahlung auf der Schwarzkörperkurve in der CIE-Normfarbtafel, mit einer Toleranz von höchstens 0,03 Einheiten oder von höchstens 0,015 Einheiten liegen. Insbesondere liegt dieser Farbort mit der genannten Toleranz auf der Schwarzkörperkurve bei einer korrelierten Farbtemperatur von 3000 K.
Gemäß zumindest einer Ausführungsform wird von dem ersten Leuchtstoff ein höherer Strahlungsanteil der von dem ersten Leuchtdiodenchip erzeugten Strahlung absorbiert, relativ zu dem Strahlungsanteil des zweiten Leuchtdiodenchips, der von dem zweiten Leuchtstoff absorbiert wird. Mit anderen Worten weist dann die erste Mischstrahlung einen kleineren Blauanteil auf als die zweite Mischstrahlung.

Dem erfindungsgemäßen Leuchtdiodenmodul zufolge, kann die erste Hauptwellenlänge kleiner als die zweite Hauptwellenlänge sein. Ein Wellenlängenunterschied zwischen den Hauptwellenlängen liegt dann bevorzugt bei mindestens 6 nm oder bei mindestens 8 nm. Alternativ oder zusätzlich liegt dieser Wellenlängenunterschied bei höchstens 18 nm oder bei höchstens 15 nm.

Dem erfindungsgemäßen Leuchtdiodenmodul zufolge, kann die erste Hauptwellenlänge gleich der zweiten Hauptwellenlänge, insbesondere mit einer Toleranz von höchstens 3 nm oder von höchstens 1 nm sein. Mit anderen Worten können dann der erste Leuchtdiodenchip und der zweite Leuchtdiodenchip baugleich sein, im Rahmen der Herstellungstoleranzen.

Dem erfindungsgemäßen Leuchtdiodenmodul zufolge, kann der zweite Leuchtdiodenchip dazu eingerichtet sein, mit mindestens 15 % oder mit mindestens 25 % und/oder mit höchstens 60 % oder mit höchstens 50 % der Stromdichte und/oder des Lichtstroms des ersten Leuchtdiodenchips betrieben zu werden. Die genannten Werte hinsichtlich der Stromdichte gelten insbesondere für baugleiche erste und zweite Leuchtdiodenchips. Weist der erste Leuchtdiodenchip eine von dem zweiten Leuchtdiodenchip unterschiedliche aktive, lichterzeugende Fläche auf, so sind die Werte für die Stromdichte entsprechend umzurechnen oder als Kenngröße ist der Lichtstrom heranzuziehen. Zum Beispiel werden dann die Leuchtdiodenchips ungefähr mit der gleichen Stromdichte betrieben, falls der zweite Leuchtdiodenchip eine kleinere aktive Fläche aufweist als der erste Leuchtdiodenchip.

Dem erfindungsgemäßen Leuchtdiodenmodul zufolge, können die Leuchtdiodenchips variabel bestrombar sein. Mit anderen Worten können im Betrieb des Leuchtdiodenmoduls die relativen Ströme des ersten, zweiten und dritten Leuchtdiodenchips zueinander variabel eingestellt werden. Hierdurch kann eine Farbtemperatur des von dem Leuchtdiodenmodul emittierten weißen Lichts durchgestimmt werden. Ein Durchstimmbereich beträgt hierbei bevorzugt mindestens 1600 K oder mindestens 2500 K oder mindestens 3000 K. Beispielsweise liegt der Durchstimmbereich zwischen einschließlich 2700 K und 6000 K. Es kann hierbei eine Stromstärke geregelt werden oder es findet Pulsweitenmodulation Anwendung.

Dem erfindungsgemäßen Leuchtdiodenmodul zufolge, kann der von dem dritten Leuchtdiodenchip erzeugte Anteil an dem von dem Leuchtdiodenmodul insgesamt emittierten Lichtstrom bei mindestens 3 % oder bei mindestens 5 % oder bei mindestens 10 % liegen. Alternativ oder zusätzlich liegt dieser Anteil bei höchstens 30 % oder bei höchstens 25 % oder bei höchstens 20 %. Mit anderen Worten trägt der dritte Leuchtdiodenchip dann zu einer Helligkeit des Leuchtdiodenmoduls nur vergleichsweise wenig bei.

Dem erfindungsgemäßen Leuchtdiodenmodul zufolge, kann der erste Leuchtstoff ein Y₃Al₅O₁₂:Ce oder ein Y₃(Al,Ga)₅O₁₂:Ce sein. Der Ce-Gehalt liegt bevorzugt bei mindestens 2 % oder bei mindestens 3 % und/oder bei höchstens 6 % oder bei höchstens 5 %, insbesondere bei ungefähr 4 %.

Dem erfindungsgemäßen Leuchtdiodenmodul zufolge, kann der zweite Leuchtstoff ein Y₃(Al,Ga)₅O₁₂:Ce, ein (Lu,Y)₃(Al,Ga)₅O₁₂:Ce, ein Lu₃(Al,Ga)₅O₁₂:Ce, ein Orthosilikat oder ein Nitrido-Orthosilikat sein. Der Ce-Anteil beträgt bevorzugt mindestens 1,5 % oder mindestens 2 % und/oder höchstens 5 % oder höchstens 4 %, insbesondere ungefähr 3 %. Insbesondere im Falle von Lu₃(Al,Ga)₅O₁₂:Ce liegt der Ga-Anteil bevorzugt bei mindestens 20 % und/oder bei höchstens 30 %, insbesondere bei ungefähr 25 %.

Dem erfindungsgemäßen Leuchtdiodenmodul zufolge, kann dem ersten und/oder dem zweiten Leuchtdiodenchip ein erster Streukörper nachgeordnet sein. Der erste Streukörper weist bei Raumtemperatur, insbesondere bei ungefähr 300 K, ein kleineres Streuvermögen auf als bei einer stationären Betriebstemperatur des Leuchtdiodenmoduls. Die stationäre Betriebstemperatur liegt insbesondere bei mindestens 350 K oder 360 K und/oder bei höchstens 400 K oder 425 K, etwa bei ungefähr 375 K.

Dem erfindungsgemäßen Leuchtdiodenmodul zufolge, kann der erste Streukörper ein Matrixmaterial und in das Matrixmaterial eingebettete Streupartikel aufweisen. Ein Brechungsindexunterschied zwischen diesem Matrixmaterial und diesen Streupartikeln ist bei Raumtemperatur kleiner als bei der stationären Betriebstemperatur. Bevorzugt liegt der Brechungsindexunterschied bei Raumtemperatur bei mindestens 0,025 oder 0,03 und/oder bei höchstens 0,05 und bei der stationären Betriebstemperatur bei höchstens 0,02 oder höchstens 0,01.
Mit anderen Worten steigt bei einem solchen ersten Streukörper mit zunehmender Temperatur hin zur stationären Betriebstemperatur eine streuende Wirkung. Dies führt dazu, dass in dem Leuchtstoff mit zunehmender Temperatur die Strahlung der ersten Hauptwellenlänge eine größere mittlere Weglänge zurücklegt und somit eine Konversionseffizienz dieser Strahlung ansteigt. Es gelangt dann weniger Strahlung der ersten Hauptwellenlänge oder der zweiten Hauptwellenlänge aus dem Leuchtdiodenmodul, wenn sich die Temperatur erhöht.

Bei zunehmender Temperatur nimmt in der Regel die Absorption und die Konversionseffizienz des Leuchtstoffs ab. Hieraus resultiert im Normalfall eine Verschiebung des resultierenden Farborts in Richtung blau. Dieser Effekt ist durch einen Streukörper, der mit steigender Temperatur stärker streut, zumindest zum Teil kompensierbar.
Durch einen derartigen Streukörper ist der Anteil des blauen Lichts an der ersten und zweiten Mischstrahlung bei steigender Temperatur hin zur stationären Betriebstemperatur verkleinerbar und der Effekt des Verschiebens der Wellenlänge der von dem ersten und zweiten Leuchtdiodenchip emittierten Strahlung ist reduzierbar oder kompensierbar.
Besonders bevorzugt ist der erste Streukörper in einem Körper, der den ersten oder den zweiten Leuchtstoff enthält, integriert. Mit anderen Worten handelt es sich dann beispielsweise um ein einziges Plättchen, das dem ersten und/oder dem zweiten Leuchtdiodenchip nachgeordnet ist und das sowohl den ersten Streukörper als auch den ersten Leuchtstoff oder den zweiten Leuchtstoff beinhaltet.

Dem erfindungsgemäßen Leuchtdiodenmodul zufolge, kann dem dritten Leuchtdiodenchip ein zweiter Streukörper nachgeordnet sein. Der zweite Streukörper weist bei einer Temperatur von 300 K ein größeres Streuvermögen auf als bei der stationären Betriebstemperatur von ungefähr 375 K. Der zweite Streukörper weist ebenso ein Matrixmaterial und in das Matrixmaterial eingebettete Streupartikel auf, wobei ein Brechungsindexunterschied zwischen diesem Matrixmaterial und diesen Streupartikeln bei Raumtemperatur größer ist als bei der stationären Betriebstemperatur. Bevorzugt liegt der Brechungsindexunterschied bei Raumtemperatur bei höchstens 0,05 oder bei höchstens 0,04 und/oder bei mindestens 0,01 oder mindestens 0,03. Bei der stationären Betriebstemperatur liegt der Brechungsindexunterschied insbesondere bei höchstens 0,01 oder höchstens 0,03, bevorzugt bei ungefähr Null.
Bei einem solchen zweiten Streukörper nimmt also die Streuwirkung mit zunehmender Temperatur ab. Eine Durchlässigkeit des zweiten Streukörpers für rotes Licht nimmt dann mit steigender Temperatur hin zur stationären Betriebstemperatur ebenfalls zu. Hierdurch ist eine Abnahme der Effizienz des dritten Leuchtdiodenchips, hin zur stationären Betriebstemperatur, zumindest zum Teil kompensierbar.

Dem erfindungsgemäßen Leuchtdiodenmodul zufolge, kann der erste und/oder der zweite Streukörper als Matrixmaterial ein Silikon, ein Silikon-Epoxid-Hybridmaterial oder ein Epoxid aufweisen. Bei dem Matrixmaterial des ersten Streukörpers handelt es sich beispielsweise um ein niedrig-brechendes Silikon, etwa mit einem Brechungsindex von 1,41 +/- 0,02 bei 300 K. Bei dem Matrixmaterial des zweiten Streukörpers kann es sich um ein hoch-brechendes Silikon mit einem Brechungsindex von etwa 1,51 +/- 0,02 bei Raumtemperatur handeln. Die Streupartikel des ersten und/oder des zweiten Streukörpers sind aus einem oder mehreren der nachfolgend genannten Materialien gebildet oder bestehen hieraus: Einem Glas, Quarz, Siliziumdioxid, einem Metallfluorid wie Bariumfluorid, Calciumfluorid oder Magnesiumfluorid. Die Brechungsindices dieser Materialien für die Streupartikel ändern sich in Abhängigkeit von der Temperatur nur wenig, im Vergleich zum Brechungsindex des Matrixmaterials.

Ein mittlerer Durchmesser der Streupartikel beträgt beispielsweise mindestens 50 nm oder mindestens 150 nm oder mindestens 250 nm oder mindestens 400 nm. Alternativ oder zusätzlich liegt der mittlere Durchmesser der Streupartikel bei höchstens 20 µm oder höchstens 12 µm oder höchstens 8 µm oder höchstens 2 µm. Ein Gewichtsanteil der Streupartikel, bezogen auf das Matrixmaterial, liegt bevorzugt bei mindestens 1 % und/oder bei höchstens 50 % oder höchstens 20 % oder höchstens 12 % oder höchstens 5 %.

Dem erfindungsgemäßen Leuchtdiodenmodul zufolge, können die Leuchtstoffe Leuchtstoffpartikel aufweisen, die in ein Matrixmaterial eingebettet sind. Bei dem Matrixmaterial für die Leuchtstoffpartikel kann es sich um das gleiche Material handeln wie für die Streupartikel. Ein mittlerer Durchmesser der Leuchtstoffpartikel liegt beispielsweise bei mindestens 2 µm oder bei mindestens 3 µm oder bei mindestens 5 µm. Alternativ oder zusätzlich beträgt der mittlere Durchmesser höchstens 20 µm oder höchstens 15 µm oder höchstens 40 µm. Bevorzugt weisen die Leuchtstoffpartikel einen größeren Durchmesser auf als die Streupartikel.

Dem erfindungsgemäßen Leuchtdiodenmodul zufolge, kann den Leuchtdiodenchips gemeinsam eine Abdeckschicht nachgeordnet sein. Die Abdeckschicht beinhaltet mindestens ein Streumittel. Mittels der Abdeckschicht ist eine Durchmischung der von den einzelnen Leuchtdiodenchips, gemeinsam mit den Leuchtstoffen, emittierten Strahlungsanteile verbesserbar. Die Abdeckschicht kann als eine Abdeckplatte geformt sein, die den Leuchtdiodenchips nachgeordnet ist. Ebenso kann es sich bei der Abdeckschicht um einen Verguss handeln, in den die Leuchtdiodenchips eingebettet sind.

Nachfolgend wird ein hier beschriebenes Leuchtdiodenmodul unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Schnittdarstellung eines Ausführungsbeispiels eines hier beschriebenen Leuchtdiodenmoduls, und
- Figuren 2 - 7: schematische Illustrationen zu optischen Eigenschaften von Ausführungsbeispielen von hier beschriebenen Leuchtdiodenmodulen.

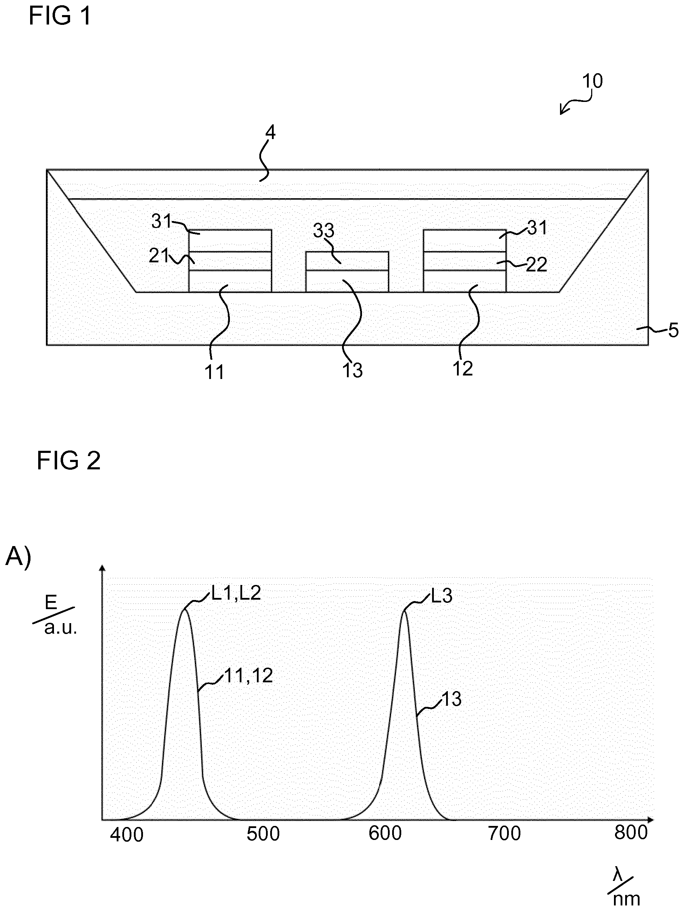

In Figur 1 ist ein Ausführungsbeispiel eines Leuchtdiodenmoduls 10 dargestellt. An einem Träger 5 ist ein erster Leuchtdiodenchip 11, ein zweiter Leuchtdiodenchip 12 sowie ein dritter Leuchtdiodenchip 13 angebracht. Die Leuchtdiodenchips 11, 12 sind zur Erzeugung von blauem Licht eingerichtet, der dritte Leuchtdiodenchip 13 zur Erzeugung von rotem Licht. Dem ersten Leuchtdiodenchip 11 ist ein erster Leuchtstoff 21 und dem zweiten Leuchtdiodenchip 12 ein zweiter Leuchtstoff 22 zugeordnet. Die Leuchtstoffe 21, 22 sind beispielsweise in einem plättchenförmigen Körper integriert und können direkt auf den Leuchtdiodenchips 11, 12 aufgebracht sein, beispielsweise aufgedruckt oder über einen Kleber aufgeklebt.

Optional ist den beiden Leuchtdiodenchips 11, 12 jeweils ein erster Streukörper 31 nachgeordnet. Anders als dargestellt kann der erste Streukörper 31 in den Körpern für die Leuchtstoffe 21, 22 integriert sein. Bevorzugt ist dem dritten Leuchtdiodenchip 13 ein zweiter Streukörper 33 nachgeordnet. Die ersten Streukörper 31 weisen mit zunehmender Temperatur, hin zu einer stationären Betriebstemperatur, eine stärker streuende Wirkung auf. Der zweite Streukörper 33 weist hin zur stationären Betriebstemperatur, ausgehend von Raumtemperatur, eine abnehmende oder verschwindende Streuwirkung auf.

Ferner optional ist den Leuchtdiodenchips 11, 12, 13 eine Abdeckschicht 4 nachgeordnet, die ein Streumittel zu einer Homogenisierung der von den Halbleiterchips 11, 12, 13 emittierten Strahlung aufweist. Anders als dargestellt kann die Abdeckschicht 4 nicht als Platte, sondern auch als Verguss realisiert sein.

Gemäß Figur 1 ist jeweils nur ein erster Leuchtdiodenchip 11, ein zweiter Leuchtdiodenchip 12 sowie ein dritter Leuchtdiodenchip 13 vorhanden. Abweichend hiervon können jeweils mehrere der Leuchtdiodenchips 11, 12, 13 in dem Leuchtdiodenmodul 10 eingesetzt sein. In der Darstellung gemäß Figur 1 befindet sich der dritte Leuchtdiodenchip 13 zwischen den beiden Leuchtdiodenchips 11, 12. Eine andere Anordnung der Leuchtdiodenchips 11, 12, 13 ist ebenso realisierbar.

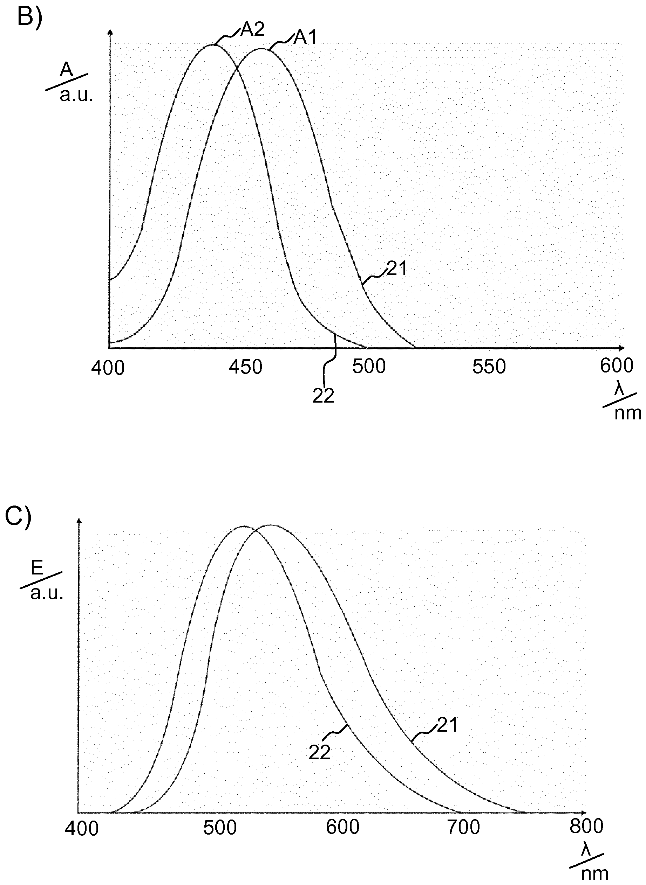

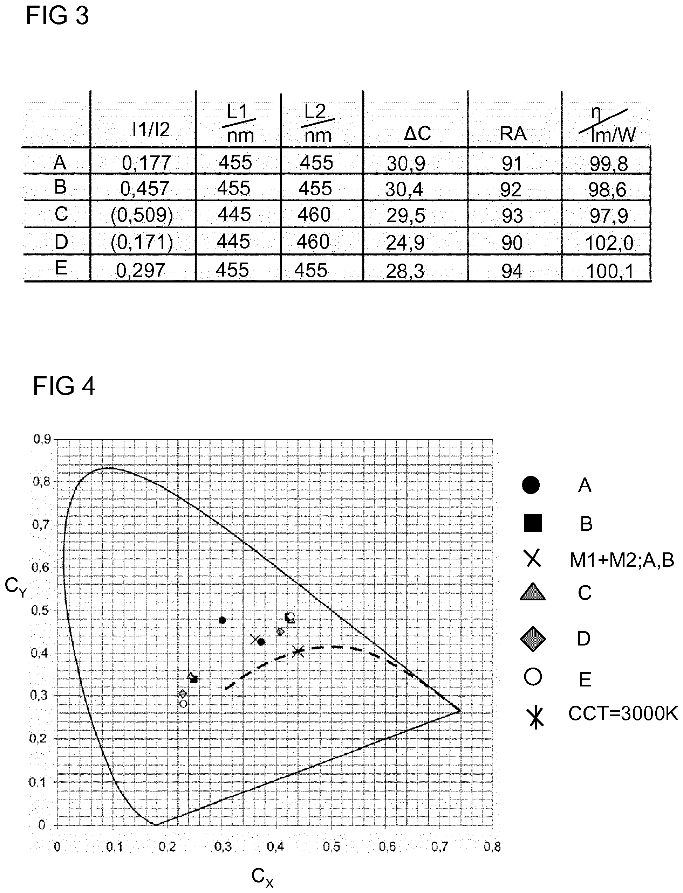

In den Spektren gemäß Figur 2 sowie der Tabelle gemäß Figur 3 sind optische Eigenschaften sowie Betriebsparameter für die nachfolgend genannten Ausführungsbeispiele näher erläutert. In der Tabelle der Figur 3 ist jeweils angegeben ein Verhältnis der Ströme I2 durch den zweiten Leuchtdiodenchip 12 und I1 durch den ersten Leuchtdiodenchip 11, die Hauptwellenlängen L1, L2 der Leuchtdiodenchips 11, 12, eine Farbortverschiebung ΔC, ein Farbwiedergabeindex RA sowie eine Effizienz η. Die Farbortverschiebung ΔC ist in MacAdam-Schritten angegeben, bezogen auf eine Temperaturdifferenz von 90 °C auf 25 °C. Werden andere Leuchtstoffe oder Leuchtdiodenchips verwendet, so sind die hiervon abhängigen Parameter jeweils dementsprechend anzupassen.

In Figur 2A sind Emissionsspektren der Leuchtdiodenchips 11, 12, 13 schematisch und normiert dargestellt. Die ersten und zweiten Leuchtdiodenchips 11, 12 weisen eine gleiche Hauptwellenlänge L1, L2 auf, die bei ungefähr 455 nm liegt. Solche Leuchtdiodenchips 11, 12 sind in den Ausführungsbeispielen A, B und E verbaut. Der dritte Leuchtdiodenchip 13 weist jeweils eine dritte Hauptwellenlänge L3 auf, die bei ungefähr 625 nm liegt. Ein entsprechender dritter Leuchtdiodenchip 13 ist in den Ausführungsbeispielen A bis E verwendet.

Ebenfalls für alle Ausführungsbeispiele A bis E sind die Leuchtstoffe gemäß der Figuren 2B und 2C verwendet. Der erste Leuchtstoff 21 weist ein Absorptionsmaximum A1 bei ungefähr 460 nm auf. Bei dem ersten Leuchtstoff 21 handelt es sich um einen YAG:Ce mit einem Ce-Gehalt von 4 %. Der zweite Leuchtstoff 22 weist ein Absorptionsmaximum A2 bei ungefähr 435 nm auf und ist durch einen LuAGaG:Ce mit 25 % Ga und 3 % Ce gebildet. Der zweite Leuchtstoff 22 emittiert bei einer kürzeren Emissionswellenlänge als der erste Leuchtstoff 21, siehe Figur 2C.

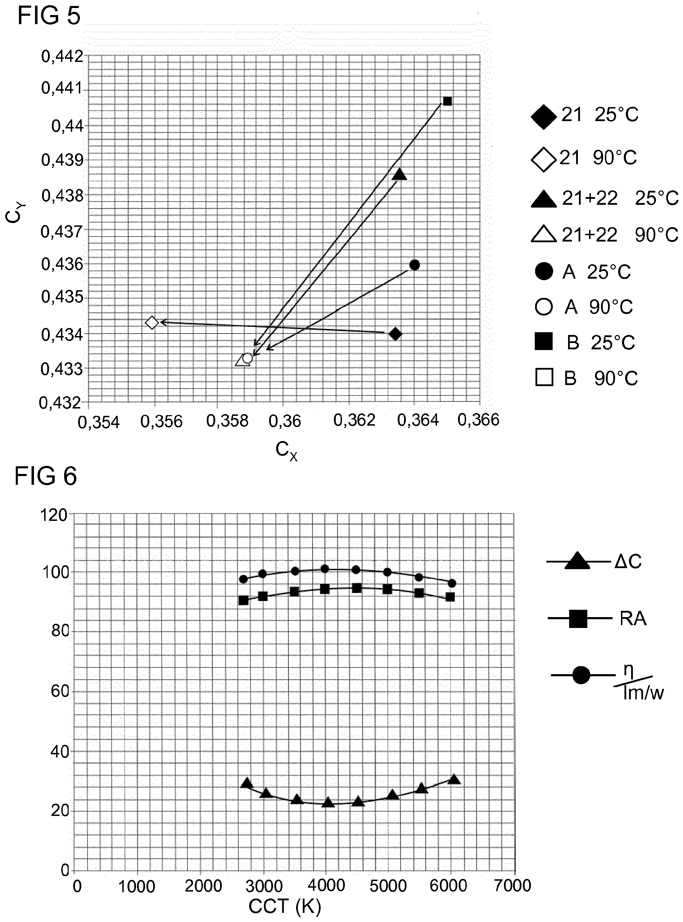

Gemäß dem Beispiel A, vergleiche auch Figur 1, ist den Leuchtdiodenchips 11, 12 jeweils einer der Leuchtstoffe 21, 22 zugeordnet. Ein Farbort der entsprechenden Mischstrahlungen M1, M2, gebildet durch eine Mischung aus der von dem Leuchtdiodenchip 11, 12 emittierten Strahlung und der durch den zugehörigen Leuchtstoff 21, 22 konvertierten Strahlung, ist in Figur 4 zu sehen. Ein Mischfarbort aus den Mischstrahlungen M1, M2 ist ebenfalls in Figur 4 eingezeichnet.
Die Leuchtstoffkonzentrationen der Leuchtstoffe 21, 22 wurden jeweils getrennt voneinander so eingestellt, dass sich mit jedem der beiden Leuchtdiodenchips 11, 12, zusammen mit dem zugehörigen Leuchtstoff 21, 22, und gemeinsam mit dem dritten Leuchtdiodenchip 13 ein Farbort bei einer Farborttemperatur von 3000 K auf der Schwarzkörperkurve näherungsweise treffen lässt, siehe Figur 4. Der zweite Leuchtdiodenchip 12 wird nur mit etwa einem Fünftel des Stroms des ersten Leuchtdiodenchips 11 betrieben, wobei die beiden Leuchtdiodenchips 11, 12 baugleich sind, siehe die Tabelle in Figur 3.
Eine Verschiebung ΔC des Mischfarborts aus den Mischstrahlungen M1, M2 von den Leuchtdiodenchips 11, 12 und den Leuchtstoffen 21, 22 ist in Figur 5 dargestellt, bezogen auf Temperaturen von 25 °C und 90 °C. Im Vergleich zu einer Leuchtstofflösung mit nur dem ersten Leuchtstoff 21, vergleiche die Rauten in Figur 5, und verglichen mit einer Leuchtstoffmischung aus den Leuchtstoffen 21, 22 auf einem einzigen Leuchtdiodenchip, vergleiche die Dreiecke in Figur 5, ist eine Farbortverschiebung beim Ausführungsbeispiel A, siehe die Kreise, reduziert.

Bei einem weiteren Beispiel B ist der erste Leuchtstoff 21 auf dem ersten Leuchtdiodenchip 11 höher konzentriert als der zweite Leuchtstoff 22 auf dem zweiten Leuchtdiodenchip 12. Die Mischstrahlung M2 ist daher weiter in das Blaue verschoben als beim Ausführungsbeispiel A, siehe Figur 4. Ein Mischfarbort aus den Mischstrahlungen M1, M2 entspricht dem des Ausführungsbeispiels A, siehe ebenfalls Figur 4. Hierdurch ist eine Farbortverschiebung hin zur Betriebstemperatur weiter reduzierbar, im Vergleich zum Ausführungsbeispiel A, siehe auch die Quadrate in Figur 5. Ein Vorteil beim Ausführungsbeispiel B ist, dass Abweichungen der Leuchtstoffkonzentrationen der Leuchtstoffe 21, 22 von einem Sollwert in der Produktion aufgrund von Fertigungstoleranzen durch Variation eines Verhältnisses I2/I1 von Strömen durch die Leuchtdiodenchips 11, 12 einstellbar ist.

Beim Beispiel C, siehe auch die Tabelle in Figur 3, weisen die Leuchtdiodenchips 11, 12 unterschiedliche Hauptwellenlängen L1, L2 auf. Ein Unterschied zwischen den Hauptwellenlängen L1, L2 liegt bei ungefähr 15 nm. Hierdurch ist ein höherer Farbwiedergabeindex RA erzielbar.

Beim Beispiel C ist die erste Hauptwellenlänge L1 kleiner als die zweite Hauptwellenlänge L2. Hierdurch liegt die von dem ersten Leuchtdiodenchip 11 emittierte Strahlung in einem Wellenlängenbereich mit einer mit steigender Temperatur größeren Absorptionsänderung des ersten Leuchtstoffs 21. Umgekehrt wurde der zweite Leuchtdiodenchip 12 langwelliger emittierend gewählt, so dass die Absorption des zweiten Leuchtstoffs 22 bei Verschiebung zu größeren Wellenlängen stärker zurückgeht.

Da im Beispiel C unterschiedliche Leuchtdiodenchips 11, 12 verwendet sind, sind die Werte für den Strom in der Tabelle der Figur 3 nur grobe Richtwerte und daher in Klammern angegeben.

Beim Beispiel D wurde der Anteil des Lichtstroms des dritten Leuchtdiodenchips 13 an der Gesamtstrahlung des Leuchtdiodenmoduls 10 weiter reduziert. Die Mischstrahlungen M1, M2, siehe Figur 4, sind beim Ausführungsbeispiel D näher an die Schwarzkörperkurve in der CIE-Normfarbtafel gerückt. Ein Abstand zur Schwarzkörperkurve beträgt jeweils bevorzugt höchstens 0,7 oder höchstens 0,6 oder höchstens 0,5 Einheiten.
Mit anderen Worten werden die Farborte der Mischstrahlungen M1, M2 näher zu dem Farbpunkt des von dem Leuchtdiodenmodul 10 insgesamt emittierten, weißen Lichts gerückt. Eine Reduzierung des Farbwiedergabeindexes RA hierdurch ist durch die unterschiedlichen Hauptwellenlängen L1, L2 kompensierbar. Weiterhin sind eine besonders geringe Farbortverschiebung ΔC und eine hohe Effizienz η erreichbar, siehe Figur 3.

Das Beispiel E basiert auf dem Ausführungsbeispiel B. Zusätzlich sind die Leuchtdiodenchips 11, 12, 13 elektrisch unabhängig voneinander betreibbar. Hierdurch ist eine korrelierte Farbtemperatur der weißen Gesamtstrahlung über einen Bereich von 2700 K bis 6000 K einstellbar, siehe Figur 6. Die mittlere Farbortverschiebung ΔC bei einer bestimmten korrelierten Farbtemperatur ist dabei vergleichsweise gering, siehe ebenso Figur 6. Der Farbwiedergabeindex RA liegt jeweils oberhalb von 90 und die Effizienz η liegt jeweils bei ungefähr 100 lm/W.

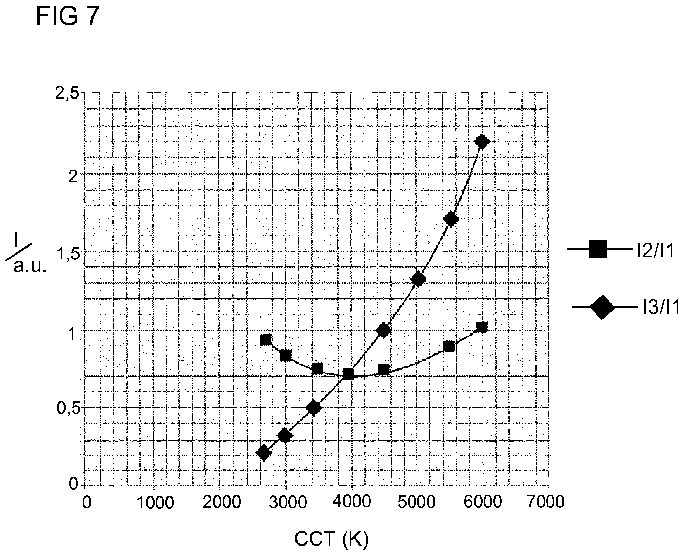

Die Verhältnisse der Ströme I1, I2, I3 durch die Leuchtdiodenchips 11, 12, 13 sind in Figur 7 illustriert. Da insbesondere die Effizienz des auf InAlGaP basierenden dritten Leuchtdiodenchips 13 variieren kann, sind die dargestellten Werte nur als grobe Richtwerte zu verstehen.

In allen Beispielen können die in Verbindung mit Figur 1 gezeigten Streukörper 31, 33 und/oder die Abdeckschicht 4 vorhanden sein. Der erste Leuchtstoff 21 ist bevorzugt ein Granat. Der zweite Leuchtstoff 22 ist bei den dargestellten Ausführungsbeispielen jeweils ein Granat, kann aber ebenso ein Eu-dotiertes Orthosilikat oder Nitrido-Orthosilikat sein.
Die hier beschriebene Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Leuchtdiodenmodul (10) mit
- mindestens einem ersten Leuchtdiodenchip (11), der zur Erzeugung von Strahlung im blauen Spektralbereich mit einer ersten Hauptwellenlänge (L1) eingerichtet ist,
- mindestens einem zweiten Leuchtdiodenchip (12), der zur Erzeugung von Strahlung im blauen Spektralbereich mit einer zweiten Hauptwellenlänge (L2) eingerichtet ist,
- mindestens einem dritten Leuchtdiodenchip (13), der zur Erzeugung von Strahlung im roten Spektralbereich mit einer dritten Hauptwellenlänge (L3) eingerichtet ist,
- einem ersten Leuchtstoff (21), der dem ersten Leuchtdiodenchip (11) nachgeordnet ist, und
- einem zweiten Leuchtstoff (22), der dem zweiten Leuchtdiodenchip (12) nachgeordnet ist,
wobei
- das Leuchtdiodenmodul (10) zur Abstrahlung von weißem Licht eingerichtet ist,
- der erste Leuchtdiodenchip (11) zusammen mit dem ersten Leuchtstoff (21) eine erste Mischstrahlung (M1) und der zweite Leuchtdiodenchip (21) zusammen mit dem zweiten Leuchtstoff (22) eine zweite Mischstrahlung (M2) erzeugen, wobei die erste Hauptwellenlänge (L1) und die zweite Hauptwellenlänge (L2) zwischen einschließlich 440 nm und 465 nm liegen sowie die dritte Hauptwellenlänge (L3) zwischen einschließlich 610 nm und 670 nm liegt, **dadurch gekennzeichnet dass**
- der erste Leuchtstoff (21) ein erstes Absorptionsmaximum (A1) bei einer Wellenlänge aufzeigt, die größer ist als die erste Hauptwellenlänge (L1), und
- der zweite Leuchtstoff (21) ein zweites Absorptionsmaximum (A2) bei einer Wellenlänge aufzeigt, die kleiner ist als die zweite Hauptwellenlänge (L2),
dass der erste Leuchtstoff (21) eine dominante Emissionswellenlänge größer 570 nm und der zweite Leuchtstoff (22) eine dominante Emissionswellenlänge kleiner 570 nm aufweist,
wobei das erste Absorptionsmaximum (A1) des ersten Leuchtstoffs (21) zwischen einschließlich 450 nm und 470 nm liegt und das zweite Absorptionsmaximum (A2) des zweiten Leuchtstoff (22) zwischen einschließlich 425 nm und 442 nm.

2. Leuchtdiodenmodul (10) nach einem der vorhergehenden Ansprüche,
bei dem
- ein Farbort der ersten Mischstrahlung (M1) in der CIE-Normfarbtafel von einem Viereck mit den Eckpunkten (0,32; 0,36), (0,48; 0,48), (0,40; 0,56) und (0,32; 0,40) umfasst ist, wobei die Eckpunkte durch die (cₓ; c_{y})-werte definiert sind,
- ein Farbort der zweiten Mischstrahlung (M2) in der CIE-Normfarbtafel von einem Viereck mit den Eckpunkten (0,22; 0,20), (0,30; 0,40), (0,24; 0,46) und (0,18; 0,22) umfasst ist, und
- ein Mischfarbort aus den Mischstrahlungen (M1, M2) von einem Viereck mit den Eckpunkten (0,34; 0,38), (0,42; 0,44), (0,38; 0,46) und (0,32; 0,42) umfasst ist.

3. Leuchtdiodenmodul (10) nach einem der vorhergehenden Ansprüche,
bei dem von dem ersten Leuchtstoff (21) ein höherer Strahlungsanteil des ersten Leuchtdiodenchips (11) absorbiert wird, im Vergleich zum Strahlungsanteil des zweiten Leuchtdiodenchips (12), der von dem zweiten Leuchtstoff (22) absorbiert wird,
sodass die erste Mischstrahlung (M1) einen kleineren Blauanteil aufweist als die zweite Mischstrahlung (M2).

4. Leuchtdiodenmodul (10) nach einem der vorhergehenden Ansprüche,
bei dem die erste Hauptwellenlänge (L1) kleiner ist als die zweite Hauptwellenlänge (L2),
wobei ein Wellenlängenunterschied zwischen den Hauptwellenlängen (L1, L2) mindestens 6 nm und höchstens 18 nm beträgt.

5. Leuchtdiodenmodul (10) nach einem der Ansprüche 1 bis3,
bei dem die erste Hauptwellenlänge (L1) gleich der zweiten Hauptwellenlänge (L2) ist, mit einer Toleranz von höchstens 3 nm.

6. Leuchtdiodenmodul (10) nach einem der vorhergehenden Ansprüche,
bei dem der zweite Leuchtdiodenchip (12) dazu eingerichtet ist, mit mindestens 15 % und mit höchstens 60 % des Stroms des ersten Leuchtdiodenchips (11) bestromt zu werden.

7. Leuchtdiodenmodul (10) nach einem der vorhergehenden Ansprüche,
bei dem die Leuchtdiodenchips (11, 12, 13) variabel bestrombar sind, sodass eine Farbtemperatur des von dem Leuchtdiodenmodul (10) emittierten weißen Lichts über einen Farbtemperaturbereich von mindestens 1600 K hinweg durchstimmbar ist.

8. Leuchtdiodenmodul (10) nach einem der vorhergehenden Ansprüche,
bei dem der von dem dritten Leuchtdiodenchip (13) erzeugte Anteil an dem von dem Leuchtdiodenmodul (10) emittierten Lichtstrom mindestens 3 % und höchstens 20 % beträgt.

9. Leuchtdiodenmodul (10) nach einem der vorhergehenden Ansprüche,
bei dem der erste Leuchtstoff (21) ein Y₃Al₅O₁₂:Ce oder ein Y₃(Al,Ga)₅O₁₂:Ce ist.

10. Leuchtdiodenmodul (10) nach einem der vorhergehenden Ansprüche,
bei dem der zweite Leuchtstoff (22) ein Y₃(Al,Ga)₅O₁₂:Ce, ein (Lu,Y)₃(Al,Ga)₅O₁₂:Ce, ein Lu₃(Al,Ga)₅O₁₂:Ce, ein Orthosilikat oder ein Nitrido-Orthosilikat ist.

11. Leuchtdiodenmodul (10) nach einem der vorhergehenden Ansprüche,
bei dem dem ersten und/oder dem zweiten Leuchtdiodenchip (11, 12) ein erster Streukörper (31, 32) nachgeordnet ist, der bei einer Temperatur von 300 K ein kleineres Streuvermögen aufweist als bei einer Temperatur von 375 K,
wobei der erste Streukörper (31) ein Matrixmaterial und in das Matrixmaterial eingebettete Streupartikel aufweist und ein Brechungsindexunterschied zwischen diesem Matrixmaterial und diesen Streupartikeln bei einer Temperatur von 300 K kleiner ist als bei 375 K.

12. Leuchtdiodenmodul (10) nach einem der vorhergehenden Ansprüche,
bei dem dem dritten Leuchtdiodenchip (13) ein zweiter Streukörper (33) nachgeordnet ist, der bei einer Temperatur von 300 K ein größeres Streuvermögen aufweist als bei einer Temperatur von 375 K,
wobei der zweite Streukörper (33) ein Matrixmaterial und in das Matrixmaterial eingebettete Streupartikel aufweist und ein Brechungsindexunterschied zwischen diesem Matrixmaterial und diesen Streupartikeln bei einer Temperatur von 300 K größer ist als bei 375 K.

13. Leuchtdiodenmodul (10) nach einem der vorhergehenden Ansprüche,
bei dem den Leuchtdiodenchips (11, 12, 13) gemeinsam eine Abdeckschicht (4) nachgeordnet ist,
wobei die Abdeckschicht (4) mindestens ein Streumittel zu einer Durchmischung der von den Leuchtdiodenchips (11, 12, 13) emittierten Strahlungsanteile umfasst.

## Claims

1. Light-emitting diode module (10) comprising
- at least one first light-emitting diode chip (11) designed for generating radiation in the blue spectral range having a first peak wavelength (L1),
- at least one second light-emitting diode chip (12) designed for generating radiation in the blue spectral range having a second peak wavelength (L2),
- at least one third light-emitting diode chip (13) designed for generating radiation in the red spectral range having a third peak wavelength (L3),
- a first phosphor (21) disposed downstream of the first light-emitting diode chip (11), and
- a second phosphor (22) disposed downstream of the second light-emitting diode chip (12),
wherein
- the light-emitting diode module (10) is designed for emitting white light,
- the first light-emitting diode chip (11) together with the first phosphor (21) generates a first mixed radiation (M1) and the second light-emitting diode chip (21) together with the second phosphor (22) generates a second mixed radiation (M2), wherein the first peak wavelength (L1) and the second peak wavelength (L2) are between 440 nm and 465 nm inclusive and the third peak wavelength (L3) is between 610 nm and 670 nm inclusive, **characterized in that**
- the first phosphor (21) exhibits a first absorption maximum (A1) at a wavelength that is greater than the first peak wavelength (L1), and
- the second phosphor (21) exhibits a second absorption maximum (A2) at a wavelength that is less than the second peak wavelength (L2) **in that** the first phosphor (21) has a dominant emission wavelength of greater than 570 nm and the second phosphor (22) has a dominant emission wavelength of less than 570 nm,
wherein the first absorption maximum (A1) of the first phosphor (21) is between 450 nm and 470 nm inclusive and the second absorption maximum (A2) of the second phosphor (22) is between 425 nm and 442 nm inclusive.

2. Light-emitting diode module (10) according to either of the preceding claims,
wherein
- a color locus of the first mixed radiation (M1) in the CIE standard chromaticity diagram is encompassed by a quadrilateral having the vertexes (0.32; 0.36), (0.48; (0.48), (0.40; 0.56) and (0.32; 0.40), wherein the vertexes are defined by the (cₓ; c_{y}) values,
- a color locus of the second mixed radiation (M2) in the CIE standard chromaticity diagram is encompassed by a quadrilateral having the vertexes (0.22; 0.20), (0.30; 0.40), (0.24; 0.46) and (0.18; 0.22), and
- a mixed color locus from the mixed radiations (M1, M2) is encompassed by a quadrilateral having the vertexes (0.34; 0.38), (0.42; 0.44), 0.38; 0.46) and (0.32; 0.42).

3. Light-emitting diode module (10) according to either of the preceding claims,
wherein a higher radiation proportion of the first light-emitting diode chip (11) is absorbed by the first phosphor (21) in comparison with the radiation proportion of the second light-emitting diode chip (12) that is absorbed by the second phosphor (22),
such that the first mixed radiation (M1) has a smaller blue proportion than the second mixed radiation (M2).

4. Light-emitting diode module (10) according to any of the preceding claims,
wherein the first peak wavelength (L1) is less than the second peak wavelength (L2),
wherein a wavelength difference between the peak wavelengths (L1, L2) is at least 6 nm and at most 18 nm.

5. Light-emitting diode module (10) according to any of Claims 1 to 3,
wherein the first peak wavelength (L1) is equal to the second peak wavelength (L2), with a tolerance of at most 3 nm.

6. Light-emitting diode module (10) according to any of the preceding claims,
wherein the second light-emitting diode chip (12) is designed to be energized with at least 15% and with at most 60% of the current of the first light-emitting diode chip (11).

7. Light-emitting module (10) according to any of the preceding claims,
wherein the light-emitting diode chips (11, 12, 13) can be energerized variably, such that a color temperature of the white light emitted by the light-emitting diode module (10) is tunable over a color temperature range of at least 1600 K.

8. Light-emitting diode module (10) according to any of the preceding claims,
wherein that proportion of the luminous flux emitted by the light-emitting diode module (10) which is generated by the third light-emitting diode chip (13) is at least 3% and at most 20%.

9. Light-emitting diode module (10) according to any of the preceding claims,
wherein the first phosphor (21) is a Y₃Al₅O₁₂:Ce or a Y₃(Al,Ga)₅O₁₂:Ce.

10. Light-emitting diode module (10) according to any of the preceding claims,
wherein the second phosphor (22) is a Y₃(Al,Ga)₅O₁₂:Ce, an (Lu,Y)₃(Al,Ga)₅O₁₂:Ce, an Lu₃(Al,Ga)₅O₁₂:Ce, an orthosilicate or a nitrido-orthosilicate.

11. Light-emitting diode module (10) according to any of the preceding claims,
wherein a first scattering body (31, 32) is disposed downstream of the first and/or the second light-emitting diode chip (11, 12), said first scattering body having a smaller scattering capability at a temperature of 300 K than at a temperature of 375 K,
wherein the first scattering body (31) comprises a matrix material and scattering particles embedded into the matrix material, and a refractive index difference between said matrix material and said scattering particles is smaller at a temperature of 300 K than at 375 K.

12. Light-emitting diode module (10) according to any of the preceding claims,
wherein a second scattering body (33) is disposed downstream of the third light-emitting diode chip (13), said second scattering body having a larger scattering capability at a temperature of 300 K than at a temperature of 375 K,
wherein the second scattering body (33) comprises a matrix material and scattering particles embedded into the matrix material, and a refractive index difference between said matrix material and said scattering particles is larger at a temperature of 300 K than at 375 K.

13. Light-emitting diode module (10) according to any of the preceding claims,
wherein a covering layer (4) is disposed jointly downstream of the light-emitting diode chips (11, 12, 13),
wherein the covering layer (4) comprises at least one scattering medium for intermixing the radiation proportions emitted by the light-emitting diode chips (11, 12, 13).

## Revendications

1. Module de diodes électroluminescentes (10) comprenant :
- au moins une première puce de diodes électroluminescentes (11), qui est conçue pour produire un rayonnement dans le domaine spectral bleu possédant une première longueur d'onde principale (L1),
- au moins une seconde puce de diodes électroluminescentes (12), qui est conçue pour produire un rayonnement dans le domaine spectral bleu possédant une seconde longueur d'onde principale (L2),
- au moins une troisième puce de diodes électroluminescentes (13), qui est conçue pour produire un rayonnement dans le domaine spectral rouge possédant une troisième longueur d'ondes principale (L3),
- un premier luminophore (21) qui est disposé en aval de la première puce de diodes électroluminescentes (11),
- un second luminophore (22) qui est disposé en aval de la seconde puce de diodes électroluminescentes (12),
dans lequel
- le module de diodes électroluminescentes (10)est conçu pour irradier de la lumière blanche,
- la première puce de diodes électroluminescentes (11) produit avec le premier luminophore (21) un premier rayonnement mixte (M1) et la seconde puce de diodes électroluminescentes (21) produit avec le second luminophore (22) un second rayonnement mixte (M2), la première longueur d'onde principale (L1) et la seconde longueur d'onde principale (L2) étant comprises entre 440 nm et 465 nm et la troisième longueur d'onde principale (L3) étant comprise entre 610 nm et 670 nm,
**caractérisé en ce que**
- le premier luminophore (21) présente un premier maximum d'absorption (A1) à une longueur d'onde supérieure à la première longueur d'onde principale (L1), et
- le second luminophore (21) présente un second maximum d'absorption (A2) à une longueur d'onde inférieure à la seconde longueur d'onde principale (L2),
et **en ce que** le premier luminophore (21) possède une longueur d'onde d'émission dominante supérieure à 570 nm et le second luminophore (22) possède une longueur d'onde d'émission dominante inférieure à 570 nm,
et dans lequel le premier maximum d'absorption (A1) du premier luminophore (21) est compris entre 450 nm et 470 nm et le second maximum d'absorption (A2) du second luminophore (22) est compris entre 425 nm et 442 nm inclus.

2. Module de diodes électroluminescentes (10) selon l'une des revendications précédentes,
dans lequel
- la localisation chromatique du premier rayonnement mixte (M1) dans le diagramme de chromaticité CIE est incluse dans un quadrilatère ayant des sommets aux coordonnées (Cₓ ; C_{y}) (0,32 ; 0,36), (0,48 ; 0,48), (0, 40 ; 0,56) et (0,32 ;0,40),
- la localisation chromatique du second rayonnement mixte (M2) dans le diagramme de chromaticité CIE est incluse dans un quadrilatère ayant des sommets aux coordonnées (Cₓ ; C_{y}) (0,22 ; 0,20), (0,30 ; 0,40), (0,24 ; 0,46) et (0,18 ; 0,22), et
- la localisation chromatique du mélange des rayonnements mixtes (M1, M2) est incluse dans un quadrilatère ayant des sommets aux coordonnées (Cₓ ; C_{y}) (0,34 ; 0,38), (0,42 ; 0,44), (0,38 ; 0,46) et (0,32 ; 0,42).

3. Module de diodes électroluminescentes (10) selon l'une quelconque des revendications précédentes,
dans lequel la proportion de rayonnement de la première puce de diodes électroluminescentes (11) absorbée par le premier luminophore (21) est supérieure à la proportion de rayonnement de la seconde puce de diodes électroluminescentes (12) absorbée par le second luminophore (22),
de telle sorte que le premier rayonnement mixte (M1) présente une proportion de bleu inférieure à celle du second rayonnement mixte (M2).

4. Module de diodes électroluminescentes (10) selon l'une quelconque des revendications précédentes,
dans lequel la première longueur d'onde principale (L1) est inférieure à la seconde longueur d'onde principale (L2), la différence entre les longueurs d'onde principales (L1, L2) étant de 6 nm au moins et de 18 nm au plus.

5. Module de diodes électroluminescentes (10) selon l'une quelconque des revendications 1 à 3,
dans lequel la première longueur d'onde principale (L1) est égale à la seconde longueur d'onde principale (L2), avec une tolérance maximale de 3 nm.

6. Module de diodes électroluminescentes (10) selon l'une quelconque des revendications précédentes,
dans lequel la seconde puce de diodes électroluminescentes (12) est agencée de manière à être alimentée entre 15 % au minimum et 60 % au maximum du courant de la première puce de diodes électroluminescentes (11).

7. Module de diodes électroluminescentes (10) selon l'une quelconque des revendications précédentes,
dans lequel les puces de diodes électroluminescentes (11, 12, 13) peuvent être alimentées en courant de façon variable, de telle manière que la température de couleur de la lumière blanche émise par le module à diodes électroluminescentes (10) est réglable dans une plage supérieure à au moins une température de couleur de 1600 K.

8. Module de diodes électroluminescentes (10) selon l'une quelconque des revendications précédentes,
dans lequel la proportion produite par la troisième puce de diodes électroluminescentes (13) dans le flux lumineux émis par le module de diodes électroluminescentes (10) est d'au moins 3 % et au maximum de 20 %.

9. Module de diodes électroluminescentes (10) selon l'une quelconque des revendications précédentes,
dans lequel le premier luminophore (21) est un Y₃Al₅O₁₂ : Ce ou un Y₃(Al,Ga)₅O₁₂ : Ce.

10. Module de diodes électroluminescentes (10) selon l'une quelconque des revendications précédentes,
dans lequel le second luminophore (22) est un Y₃(Al,Ga)₅O₁₂ : Ce, un (Lu,Y)₃(Al,Ga)₅O₁₂ : Ce, un Lu₃(Al,Ga)₅O₁₂ : Ce, un orthosilicate ou un nitruro-orthosilicate.

11. Module de diodes électroluminescentes (10) selon l'une quelconque des revendications précédentes,
dans lequel un premier corps diffusant (31, 32) est disposé en aval de la première et/ou de la seconde puce de diodes électroluminescentes (11, 12), lequel corps diffusant (31, 32) présente à une température de 300 K un pouvoir dispersant moins élevé qu'à une température de 375 K, et
le premier corps diffusant (31) comprend un matériau de matrice et des particules de diffusion incorporées dans le matériau de matrice et la différence d'indice de réfraction entre ce matériau de matrice et ces particules de diffusion à une température de 300 K est inférieure à celle obtenue à une température de 375 K.

12. Module de diodes électroluminescentes (10) selon l'une quelconque des revendications précédentes,
dans lequel un second corps diffusant (33) est disposé en aval de la troisième puce de diodes électroluminescentes (13), lequel corps diffusant (33) présente à une température de 300 K un pouvoir dispersant plus élevé qu'à une température de 375 K, et
le second corps diffusant (33) comprend un matériau de matrice et des particules de diffusion incorporées dans le matériau de matrice et la différence d'indice de réfraction entre ce matériau de matrice et ces particules de diffusion à une température de 300 K est supérieure à celle obtenue à une température de 375 K.

13. Module de diodes électroluminescentes (10) selon l'une quelconque des revendications précédentes,
dans lequel une couche de recouvrement (4) est disposée conjointement en aval des puces de diodes électroluminescentes (11, 12, 13), et
la couche de recouvrement (4) contient au moins un agent de diffusion permettant un mélange des proportions de rayonnement émises par les puces de diodes électroluminescentes (11, 12, 13).
